# EUROPEAN PATENT SPECIFICATION

(11) **EP 0 744 241 B1**
(45) Date of publication and mention of the grant of the patent: **14.11.2001**
(21) Application number: 96301406.3
(22) Date of filing: 01.03.1996
(51) Int. Cl.: B23P 11/00, B21K 25/00, H01L 21/48, H01L 23/367

(54) **Method of joining together a pair of members each having a high thermal conductivity**
Verfahren zum Verbinden zweier Werkstücke, jedes mit hoher Wärmeleitfähigkeit
Procédé pour joindre deux pièces, chacune ayant une haute conductivité thermique

(30) Priority: 16.05.1995 JP 14009295; 05.07.1995 JP 19104795
(43) Date of publication of application: 27.11.1996
(73) Proprietor: TOUSUI, Ltd., Totte-shi, Ibaragi-ken (JP)
(72) Inventor: Terada, Atsushi, Toride-shi, Ibaragi-ken (JP)
(74) Representative: Parry, Christopher Stephen

(56) References cited:
- EP-A- 0 206 980
- EP-A- 0 508 497
- DE-A- 2 153 864
- DE-A- 2 502 472
- PATENT ABSTRACTS OF JAPAN vol. 7, no. 45 (E-160), 23 February 1983 & JP 57 196552 A (NIPPON DENKI), 2 December 1982,
- PATENT ABSTRACTS OF JAPAN vol. 8, no. 35 (M-276), 15 February 1984 & JP 58 192634 A (MIZUTANI DENKI KOGYO)
- PATENT ABSTRACTS OF JAPAN vol. 97, no. 3, 31 March 1997 & JP 08 293572 A (TERADA ATSUSHI), 5 November 1996,

## Description

The present invention relates to a method of joining together a pair of members composed of a material having a high thermal conductivity as well as a product that is made by a joining method as described. The two members are constituted each by an extruded material and the joining method is typically used in assembling a heat sink unit.

Where a pair of members composed of a material having a high thermal conductivity, for example, a pair of aluminum members, are to be joined together with their thermal conductivity and electrical conductivity taken into consideration, difficulties have hitherto be encountered because they have a high capacity of heat radiation and would have been formed with an oxide film on the surface of each of these members. Thus, even by means of resistance welding or brazing, it has been found to be more difficult to join these members together than to join a pair of other metallic materials together which have rather ordinarily been used, these other materials having a limited thermal conductivity and a reasonable degree of electric resistivity.

In addition, where a pair of extruded members are to be joined together, the size of a product that is yieldable has been limited by the size of an extrusion die that can be employed. The extrusion technique is typically unable to give rise to a product that is not less than 500 mm in its width. If a product with its width more than 500 mm and having a high thermal conductivity is then to be manufactured, any attempt has been believed to be useless, say, unless a plurality of smaller products are to be welded together.

For these reasons, if a product such as a heat sink, for example, has a specification that requires a surface (hereinafter referred to a "base") to which a heat generating element is attached and which exceeds 500 mm in its width, there has hitherto been no choice but to give up a production with extruded materials or, alternatively, to join a plurality of bases together by way of welding. Although there has also been a way of fitting a pair of corrugated plates together, such a fitting alone has been found to be insufficient to fully meet the need of a thermal conductivity and an electrical conductivity which are customarily required for a heat sink.

Also, in preparing a heat sink that utilizes a liquid coolant, it has been found to be too costly if a brazing process is employed to affix a pair of plates together. Further, for example, if a die is made up from a lost wax, the die will have been reformed because of the two sizes required.

The prior art exemplified by Japanese Patent Publication JP 58 192634 A describes a method of joining together a pair of members each having a high thermal conductivity in which a first of such members is in the form of a base plate formed to have on a surface thereof a recess or groove. A second of such members is in the form of a cooling fin formed to be planar. First the plate is inserted into the groove in the base plate, and thereafter an area of the base plate around the inserted fin plate is caulked to join the two members together. In order to allow the fin plate to be inserted into the groove. the groove must be configured to be similar in shape to the insertable end portion of the fin plate. The fin plate is shown and described to be preliminarily bent with an angle of 45 degrees or more with respect to a surface that is perpendicular to the base plate in order to enhance the caulking effect. Here, a number of such individual fin plates have to be inserted into a like number of grooves formed in the base plate to provide a radiator fin assembly.

The prior art exemplified by German Offenlegungsschrift (DE OS) 25 02 472 describes a method of joining a pair of members each having high thermal conductivity by press fitting them together in which a first of such members is formed, preferably by extrusion, to have on a surface thereof a recess and a second of such members is formed, preferably by extrusion, to have on a surface thereof a projection, the projection of the second member being configured to correspond to, and to be substantially similar in shape to the recess of the first member.

Specifically, the first member described in DE OS 25 02 472 is again a cooler base plate, the recess being a groove, and the second member is a fin plate, the projection being constituted by an end portion of the fin plate. In order to allow the fin plate to be press fitted with the base plate, the find plate is shown and described to have a width that is slightly larger than the width of the groove in the base plate. Here again, a number of individual fin plates have to be (here pressure) inserted into a like number of grooves formed in the base plate to provide a cooler unit for a thyristor element.

According to the teachings of these publications, it is difficult or even impossible to assemble a heat sink or similar product having an intricate structure with a number of, say, cells, that provides an enhanced heat radiation performance, by joining together a pair of members each having high thermal conductivity. For joining or press fitting an individual fin member with a base plate member, these prior art techniques must rely on a caulking or other secondary fastening means, which have been found to be unable to provide a sufficient fastening strength between joinable members.

Caulking described in JP 58 192634 A is found to be naturally insufficient because of failure to provide enough metallic bond between the members joined. DE OS 25 02 472 employs forming notches on the side surfaces of the fin plate, possibly also on the side walls of the grooves in the base plate to enhance a facial contact in these areas. Thus, a number of individual fin plates are press fitted with one base plate and another base plate to form a cooler unit, and such cooler units are serially coupled together to provide a thyristor cooler column. A pair of fastening plates and springs are required to compensate for shortage of fastening strength in each cooler unit.

Accordingly, it is an object of the present invention to resolve deficiencies in the prior art as described and to provide a novel and improved method of joining, with an enhanced fastening strength, a pair of members together each having a high thermal conductivity (as well as a high electrical conductivity, thus to provide a product that has an joined interface which is superior in both the thermal conductivity and the electrical conductivity as well as to provide an improved product made by a method described.

Another object of the present invention is to provide a method of joining as described in which one or each of the two members may be an intricate heat sink or fin component unlike a conventional fin plate or a base plate and yet the two members can be fastened simply and easily, and with a fastening tightness that is much superior to those attainable in the conventional caulking or even press fitting process.

In order to attain the objects mentioned above, there is provided a method of joining together a pair of members composed of a material having a high thermal conductivity by fitting them together under pressure in which a first of such members is formed by extrusion to have on a surface thereof a recess and a second of such members is formed by extrusion to have on a surface thereof a projection, the said projection of the second member being configured to correspond to, and to be substantially similar in shape to, and having a width that possibly is slightly greater than that of, the said recess of the first member, the method also containing the features set forth in the following paragraphs:

The said first member has the said recess formed to lie between and as flanking on two adjacent projections, the said recess and the said adjacent projections defining a continuous joining surface of the said first member along which it is to be joined with the said second member. The said second member has the said projection formed to lie between and as flanking on two adjacent recesses, the said projection and adjacent recesses defining a continuous joining surface of the said second member along which it is to be joined with the said first member.

The said first and second members are so formed that each of the said adjacent projections of the first member and the said projection of the second member is substantially similar in shape to, and has a width that is substantially equal to or slightly greater than that of, the one of the said adjacent recesses of the second member and the said recess of the first member which is destined to correspond thereto.

The said recess and adjacent projections of the first member and the said projection and adjacent recesses of the second member each extend generally perpendicular to the said continuous joining surfaces of the first and second members, respectively.

Each of at least some of the said recess and projections of the first member or some of the said projection and recesses of the second member is provided with a portion that is inclined with a given angle to the said perpendicular to the said joining surfaces.

Then, the said first and second members are fitted under pressure together by forcibly inserting the said projection of the second member under pressure into the said recess of the first member while concurrently permitting the said adjacent projections of the first member under pressure to be forcibly inserted into the said corresponding, adjacent recesses of the second member, respectively.

The method according to the present invention may further be characterized in that:
the said projections and recesses are so configured, and the said fitting under pressure is so carried out, as in the forcible inserting stage:
1) to cause areas of the said projections and recesses with the said portion inclined to be dynamically affected under pressure and thereby plastically deformed to effect a work hardening thereof;
2) to develop an internal stress in the said areas from a contraction and expansion of the said projections entering and the said recesses receiving when driven together under pressure; and
3) to induce a dragging action in the said areas from the said stress developed and a frictional force dynamically produced between the said entering projections and receiving recesses with the said portion inclined,
thereby fastening tightly and thus joining the said two members together under a combined effect of the said work hardening, the said internal stress developed and the said dragging action induced.

Typically, the said first and second members may each be constituted by a base plate for a heat sink.

Also, one of the said first and second members may be constituted by fin means and the other by a base plate for a heat sink assembly.

According to the present invention in the method aspect thereof as described above there is attained a highly enhanced tightness of fastening between two thermally high conductivity members together and thus are highly enhanced thermal and electrical conductivities at the joining interface of the two thermally high conductivity members. It is indeed surprising that this can be achieved according to the method of the present invention, especially without mandatorily requiring any secondary means to hold, with a sufficient tightness, two members joined or fastened together. Further, according to the method or the present invention, one or each of joinable two members can be one of intricate heat sink or fin components to be assembled by joining; and yet they can be joined together with a fastening tightness that is much superior to those attainable by the conventional caulking or even press fitting process.

The present invention still further covers a product that is made according to a method of joining a pair of members each having a high thermal conductivity.

According to the present invention in a product aspect thereof a product results with a highly enhanced tightness of fastening between two thermally high conductivity members together and thus with highly enhanced thermal and electrical conductivities at the joining interface of the two thermally high conductivity members, especially without mandatorily requiring to hold, with a sufficient tightness, the two members joined or fastened together. The product can be of an intricate, even highly, heat sink assembly.

The present invention will better be understood from the following detailed description and the drawings attached hereto showing certain illustrative embodiments of the present invention. In this connection, it should be noted that such embodiments as illustrated in the accompanying drawings are intended in no way to limit the present invention, but to facilitate an explanation and understanding thereof.

In the accompanying drawings:
Fig. 1 is a perspective view diagrammatically illustrating a certain embodiment of the present invention to which the present invention has been applied to form a heat sink assembly;
Fig. 2 is a partial front view of the entire heat sink assembly shown in Fig. 1, diagrammatically illustrating a state in which fin means and a base plate has been joined together according to the present invention;
Fig. 3 is an enlarged front view diagrammatically illustrating a single fin unit in a heat sink assembly as shown in Fig. 1;
Fig. 4 is an enlarged front view diagrammatically illustrating portions at which fin means and a base plate are to be joined together according to the present invention;
Fig. 5 is an enlarged front view diagrammatically illustrating in some detail a certain form with which fin means and a base plate are to be joined together according to the present invention;
Fig. 6 is an enlarged front view diagrammatically illustrating in some detail another form with which fin means and a base plate are to be joined together according to the present invention;
Fig. 7(A) is a perspective view diagrammatically illustrating a heat sink assembly comprising a pair of heat sink units of which the respective base plates are to be joined together and in each of which fin means and a base plate have been joined together, according to the present invention;
Fig. 7(B) is an enlarged front view diagrammatically illustrating an enlarged front view of the state of the heat sink assembly shown in Fig. 7(A);
Fig. 7(C) is a further enlarged diagrammatic view illustrating a pair of base plates for a heat sink assembly as shown in Fig. 7(A), which are being joined together according to the present invention;
Fig. 7(D) is a similar view diagrammatically illustrating those base plates which have been joined according to the present invention;
Fig. 8(A) is a still further enlarged partial view illustrating a certain form of the combination of two projecting portions and two recessed portions to be fastened, respectively, according to the present invention:
Fig. 8(B) is an enlarged view in detail illustrating diagrammatically a projecting portion in an example as shown in FiG. 8(A): and
Fig. 8(C) is an enlarged view in detail illustrating diagrammatically a recessed portion in an example as shown in FiG. 8(A)

With respect to certain exemplary embodiments of the present invention that may be constituted as mentioned comprehensively above, an explanation will now be given in detail with reference to the accompanying drawings.

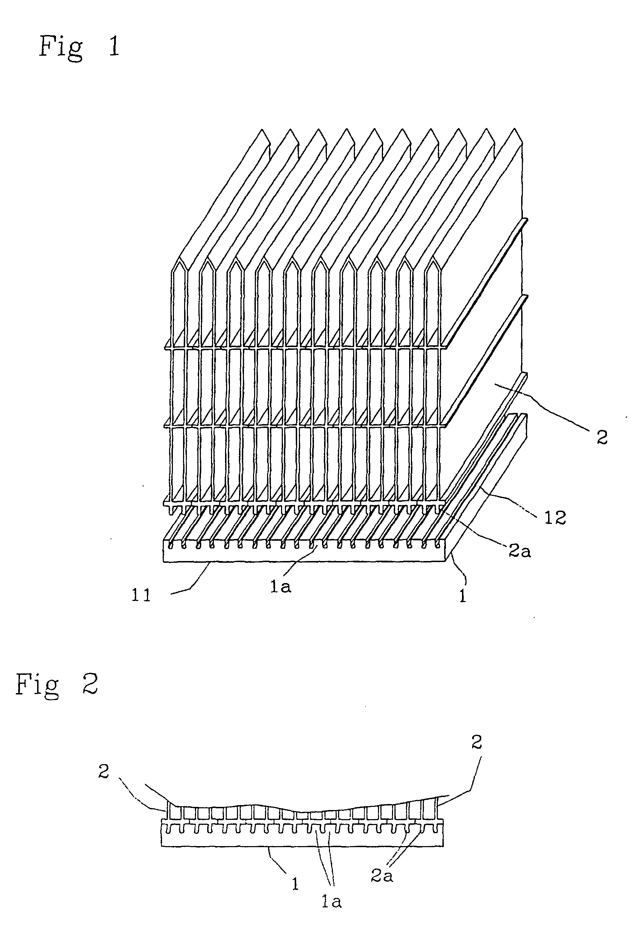

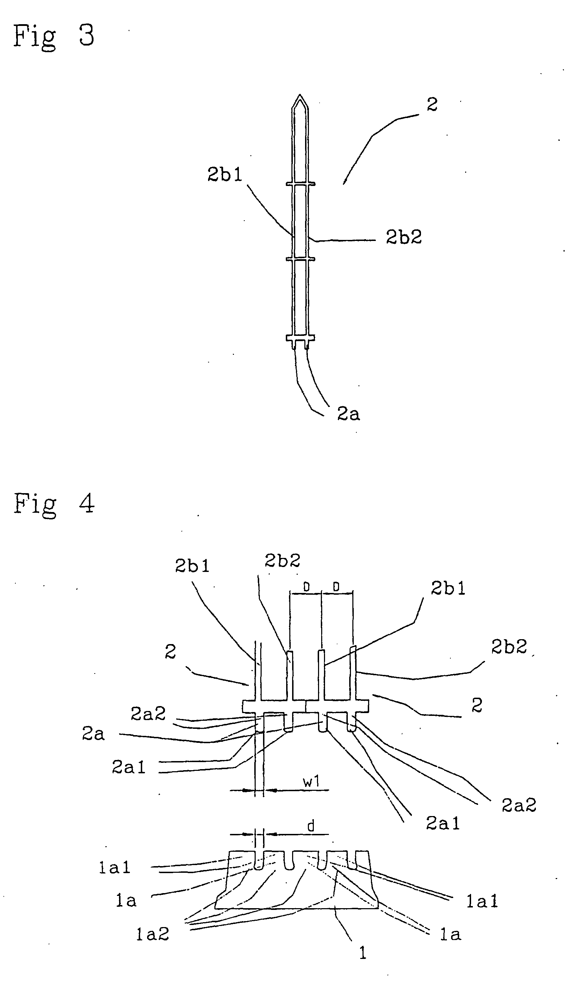

Referring now to Figs. 1 to 4, numeral 1 represents a base plate having a surface 11 to which a heat generating element (not shown) is attached; and numeral 2 designates fin means whose assembly is jointed to a surface 12 which is opposed to the attachment surface 11 for the heat generating element of the base plate 1. The base plate 1 and the fin means 2 are, here, each constructed of an extruded member that is composed of a material which is high in thermal conductivity such as, for example, aluminum. The fin means 2, as shown in Fig. 3, is constructed as having, at one end thereof, a plurality of projecting portions 2a which constitute fastening portions for joining the fin means 2 to the base plate 1 and as having side plates 2b1 and 2b2 with which small compartments are formed so as to form a radiation fin unit. The side plates 2b1 and 2b2 are shown as having an interspacing D. The fin assembly is constituted by a plurality of fin means 2 which are to be joined to the base plate 1 in order to acquire a predetermined heat radiating property for a heat sink.

As shown in Fig. 4, each projecting portion 2a at the end of each fin means 2 which extends in a vertical direction is constructed to have a predetermined width w1 and is formed at its front end with a positioning portion 2a1 and at its root side with a caulking portion 2a2. On the other hand, the base plate 1 is formed with a plurality of projecting portions 1a each of which is formed with its forward end with a positioning portion 1a1 and at its rood side with a calking portion 1a2, with the caulking portion 1a2 being inclined with an angle relative to a vertical direction. The positioning portion 2a1 is formed to have a rounded forward end whereas a recessed portion between two adjacent projecting portions 1a of the base plate 1 is formed to have a rounded bottom. Also, the width w1 of each projecting portion 2a of the fin means 2 is made identical to, or slightly larger than, a spacing or the width d of the recessed portion between two adjacent projection portions 1a of the base plate 1. Furthermore, the spacing between two adjacent projecting portions 2a of the fin means 2 is made identical to, or slightly smaller than the width of each projecting portion 1a of the base plate 1.

In order that a pressure applied downwardly from the fin means 2 or applied upwardly from the base plate 1 may, when they are fastened together, be converted to a force of fastening between the fin means 2 and the base plate 1 with certainty, the positioning portions 1a1 of the base plate 1 and the positioning portions 2a1 of the fin means 2, when the fin means 2 and the base plate 1 are fittedly inserted into each other, have a role for retaining their verticality.

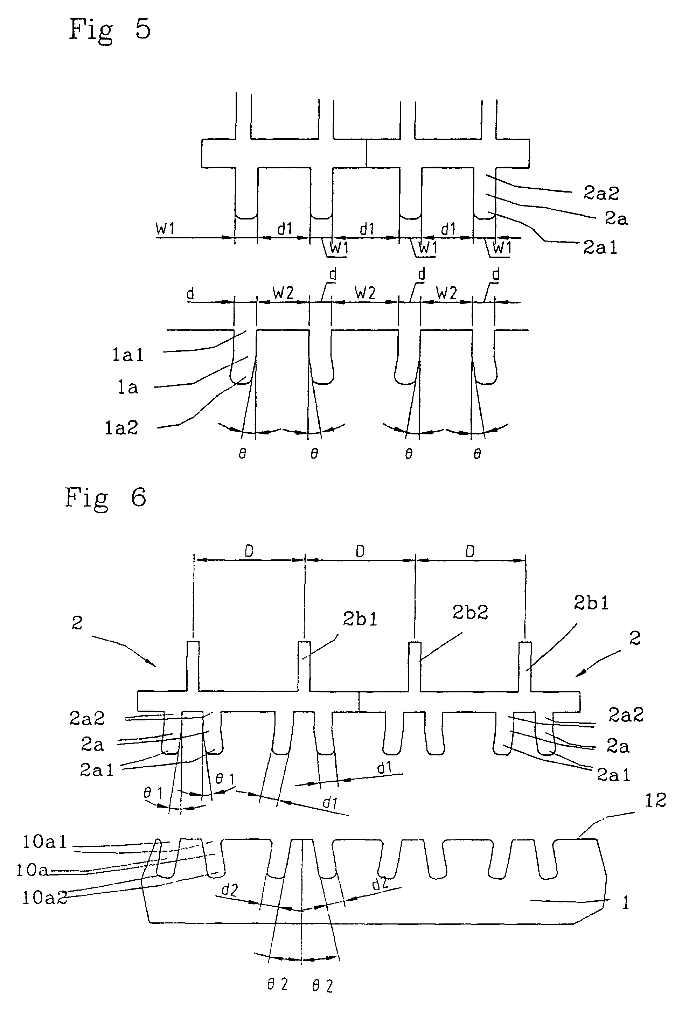

Referring to Fig. 5, numeral 1a is shown to designate a recessed portion formed between two adjacent projecting portions of the base plate 1 and having the width d. Furthermore, the interspacing between two adjacent projecting portions 2a of the fin means 2 is shown as having a width d1 whereas a projecting portion between two adjacent recessed portions 1a of the base plate 1 is shown as having a width w2. In addition, the aforementioned angle, here, at the caulking portion 1a2 of each recessed portion 1a of the base plate 1 is shown by θ, each recessed portion 1a having a positioning portion 1a1. Note also that two adjacent recessed portion are shown as being inclined (with the angle θ) in opposite direction at their caulking portions 1a1.

An explanation will now be given with respect to a method of assembling a heat sink that is constructed as mentioned above.

Prior to the assembling, it will be noted that the surface of fin means 2 and the surface of the base plate 1, which are typically each made up of an extruded aluminum material, have been each oxidated to have an oxide film of some degree of thickness formed thereon.

In the stage of assembling, by utilizing, for example, a general purpose hydraulic press or the like and a simple jig in a combination, the projecting portions 2a at the front end of each fin means 2 are fittedly inserted into recessed portions 1a between the individual projecting portions of the base plate 1 under a pressure amounting to several tens tons that is applied in a short period of time.

At the time of pressure-inserting the fin means 2 into the base plate 1, since the width d of each recessed portion 1a of the base plate 1 is made identical to, or slightly smaller than, the width w1 of each projecting portion 2a of the fin means 2, the interspacing d1 between two adjacent projecting portions 2a of the fin means 2 is made identical to, or slightly smaller than, the width w2 of each projecting portion between two adjacent recessed portions 1a of the base plate 1, the positioning portion 2a1 of each projecting portion 2a is formed to have a rounded forward end and each recessed portion 1a is formed to have a rounded bottom, it can be seen that if a large pushing pressure is applied downwardly from the fin means 2, the positioning portion 2a1 of each of the projecting portions 2a of the fin means 2 will first be introduced into the positioning portion 1a1 of each of the recessed portions 1a of the base plate 1 and will then be introduced into the caulking portions 1a2 of each recessed portion 1a of the base plate 1. At this time, since the caulking portions 1a2 of the recessed portions 1a of the base plate 1 are each inclined with the slight angle θ relative to the vertical direction, it can be seen that the positioning portion 2a1 of each projecting portion 2a of the fin means 2 which is introduced into a corresponding recessed portion 1a of the base plate 1 will be inserted fittedly into the caulking portions 1a2 of the recessed portions 1a of the base plate 1 while being bent in conformance to the inclination of these caulking portions 1a2.

At this time, since the width w1 of each of the projecting portions 2a and the width w2 of each of the projecting portions 1a are made identical to, or slightly larger than, the spacing d between the adjacent two projecting portions 1a and the spacing D between the adjacent two projecting portions 2a, respectively, it should be noted that a phenomenon called "dragging" will be generated between the respective external surfaces of the projecting portions 1a and 2a.

More specifically, with the external surface of each of the projecting portions 2a of the fin means 2 and the internal surface of each of the recessed portions 1a of the base plate 1 being in contact with each other, it can be seen that a force of friction will be generated between these surfaces and, for the reason of this frictional force, the oxide film that has been formed on each of the respective external surfaces of the projecting portions 1a and the oxide film that has been formed on each of the respective internal surfaces of the recessed portions 2a will be scraped away from each other and a dragging action will take place. As a result, an extremely intimate joining state will be established between each of the respective positioning portions 2a1 of the projecting portions 2a and a corresponding one of the respective caulking portions 1a2 of the recessed portions 1a on the one hand and between each of the respective positioning portions 1a1 of the recessed portions 1a and a corresponding one of the respective caulking portions 2a2 of the projecting portions on the other hand. Accordingly, with the projecting portions 2a and the corresponding recessed portions 1a being intimately joined, it can been seen that both the thermal conductivity and the electrical conductivity between the fin means 2 and the base plate 1 will be extremely enhanced.

It should also be noted that each portion of joining between the fin means 2 and the base plate 1 which are pressure inserted into each other will give rise to a stress in their contacting horizontal direction due to the pressure applied in the vertical direction, hence yielding their fastening result with a greater certainty.

Since the positioning portion 2a1 of each projecting portions 2a, when pressure inserted, is forcively bent with the angle θ of the caulking portion 2a2 of the corresponding recessed portion relative to the vertical direction, it should also be noted that a work-hardening effect will be produced there, thereby giving rise to the fastening result with a greater certainty.

Thus, a heat that is generated from a heat generating element will be transferred from the base plate 1 via the joining surface established between the fin means 2 and the base plate 1 as mentioned above to the fin means 2. The fin means 2 will then act to take away the heat transferred from the base plate 1 by virtue of an air flow from a fan (not shown) that is attached to the heat sink assembly.

Whilst there is no problem with respect to the joining due to the dragging action between the fin means 2 and the base plate 1 if it is effected as mentioned above, it should be noted that in a case where the fin means 2 and the base plate 1 are each constructed of an extruded material, it differs from a cut material and includes a distortion therein that has be produced in an extrusion operation. Then, the fin means 2 and the base plate 1 might not be joined owing to the "dragging" action alone with stability. Even in such a case, it should be noted that a work hardening effect will here take place based on a plastic deformation at a forcibly bent portion (i. e. the forward end of a positioning portion 2a1) when the fin means 2 and the base plate 1 are joined together and will affect a force of joining the fin means 2 to the base plate 1 together. Note here that the force of joining between the fin means 2 and the base plate 1 is directly related to a thermal conductivity at the interface between them. More specifically, this portion has a role to compensate for an inconsistency in the performance of a heat sink that results from an inconsistency in size of products. It should also be noted that even in a case where the oxide film that is produced on the external surface of each of the projecting portions is thick, thus making it impossible to develop a full dragging state, a stress at the joining surface that is produced by the pressure applied there will be capable of enhancing the thermal conductivity there.

Also, it should be noted that whilst the fin means 2 and the base plate 1 is brought into a joining state under the dragging action at the portions of the projecting portions when pressure inserted, it is also possible to carry out a preliminary step to remove an oxide film at a portion to be joined, that is, upon the external surface of each of the projecting portions by using a wire brush or the like prior to the pressure insertion. Thus, whilst the present invention enables an oxide film upon the external surface of each of the projecting portions an an oxide film upon the internal surface of each of the recessed portions to be removed by the dragging action and hence essentially makes it unnecessary to employ the above mentioned preliminary step, thus having the effects of simplifying the method of assembling and lowering the manufacturing cost, it is still possible to incorporate the above mentioned preliminary step in a case where the scraping of the oxide film by way of the dragging action can only be performed insufficiently.

It should further be noted that whilst in an example as mentioned above, the positioning portion of each projecting portion is formed to have a rounded forward end, such an end configuration is not an absolute limitation but it may, for example, be wedge shaped.

Next, Fig. 6 shows a modified embodiment of a section where the fin means 2 and the base plate 1 are to be joined together to constitute a heat sink according to the present invention.

In this embodiment, a projecting portion 2a at the front end of each fin means 2 is formed to have a predetermined width d1 and is constructed with a forward end portion 2a1 and a root end portion 2a2. It is seen that the root end portion 2a2 is formed to extend in a vertical direction and the forward end portion 2a1 is formed so as to be inclined with a small angle θ1 relative to the vertical direction. It is seen that the forward end portion 2a1 is formed to have a rounded forward end.

On the other hand, the attachment surface 12 of the base plate 1 is formed with such a plurality of recessed portions 10a as corresponding to a plurality of projecting portions 2a of the fin means 2. Such a recessed portion 10a is formed to have a width d2 that is slightly smaller than the width d1 of each projecting portion 2a and to linearly extend in a direction that is inclined with an angle θ 2 with respect to the vertical direction. It is seen that the angle θ 2 is set to be greater than the angle θ 1. It is also seen that the recessed portion 10a has a depth that corresponds to the length of the projecting portion 2a, and has a bottom which conforms to the configuration of the forward end of the projecting portion 2a.

In the stage of assembling, by utilizing, for example, a general purpose hydraulic press or the like and a simple jig in a combination, portions of the projecting portions 2a of each fin means 2 are fittedly inserted into the corresponding recessed portions 10a of the base plate 1, respectively, under a pressure amounting to several tens tons that is applied in a short period of time.

At the time of pressure-inserting the fin means 2 into the base plate 1, since the width d1 of each of the projecting portions 2a of the fin means 2 is made slightly larger than the width d2 of each recessed portion 10a of the base plate 1 and the forward end portion 2a1 of each projecting portion 20a is formed to have a rounded forward end while the. corresponding recessed portion 10a is formed to have a rounded bottom complementary thereto, it can be seen that if a large pushing pressure is applied downwardly from the fin means 2, the forward end portion 2a1 of each of the projecting portion 2a of the fin means 2 will be introduced into a corresponding recessed portion 10a of the base plate 1. At this time, since the the recessed portions 10a are each inclined with the angle θ 2 relative to the vertical direction, it can be seen that the forward end portion 2a1 and the root end portion 2a2 of each projecting portion 2a of the fin means 2 which is introduced into a corresponding recessed portion 10a of the base plate 1 will be inserted fittedly into the recessed portion 10a while being bent in conformance to the angle of inclination θ 2 thereof.

At this time, since the width d1 of each of the projecting portions 2a is made greater than the width d2 of each of the recessed portions 10a, it should be noted that a phenomenon called "dragging" will be generated between the external surface of each of the projecting portions 2a and the internal surface of each of the recessed portions 10a. More specifically, with the external surface of each of projecting portions 2a of the fin means 2 and the internal surface of each of the recessed portions 10a of the base plate 1 being in contact with each other, it can be seen that a force of friction will be generated between these surfaces and, for the reason of this frictional force, the oxide film that has been formed on each of the respective external surfaces of the projecting portions 2a and the internal surface of each of the recessed portions 10a will be scraped away and the dragging will take place. As a result, an extremely intimate joining state will be established between these surfaces. Accordingly, with the projecting portions 2a and the recessed portions 10a being intimately joined, it can been seen that both the thermal conductivity and the electrical conductivity between the fin means 2 and the base plate 1 will be extremely enhanced.

It should also be noted that each portion of joining between the fin means 2 and the base plate 1 which are pressure inserted into each other will give rise to a stress in their contacting horizontal direction due to the pressure applied in the vertical direction, hence yielding their fastening result with a greater certainty.

Since the forward end portion 2a1 of each of the projecting portions 2a of the fin means, when pressure inserted, is forcively bent with the angle θ 2 of each recessed portion 10a of the base plate 1 relative to the vertical direction, it should also be noted that a work-hardening effect will be produced there, thereby giving rise to the fastening result with a greater certainty.

Whilst an explanation has been given with respect to the various embodiments of the present invention, it will be understood that these embodiments are in no way intended to limit the present invention and a variety of modifications thereof can be made within the scope of the appended claims.

For example, it should be noted that in the embodiment shown in Fig. 6, whilst the projecting portions 2a are formed on the side of the fin means 2 and the recessed portions 10a are formed at the side of the base plate 1, it is also possible to form the recessed portions at the side of the fin means 2 and the projecting portions on the side of the base plate 1.

It should further be noted that in the various embodiments set forth in the foregoing, the configuration and the number of the projecting portions and the recessed portions can suitably be altered depending upon the magnitude of the pressure that is applied when the fin means 2 and the base plate 1 are pressure inserted into each other.

According to a method of assembling a heat sink that is provided in accordance with the present invention, it will now become apparent that neither a brazing facility nor any expensive dedicated machine for the purpose of caulking is required and a heat sink can readily be manufactured with a combination of a general purpose press or the like and a simple jig.

Also, according to a heat sink that is provided in accordance with the present invention, it will now become apparent that its thermal conductivity is sharply enhanced by the intensive action of rubbing a pair of the joining surfaces of the base plate and the fin means together which action is generated when they are fittedly inserted into each other and which acts to scrape away the oxide films previously formed thereon and thereby to refresh these joining surfaces and by rendering the refreshed surfaces in a joining state by way of dragging.

Also, with an extrusion technique and a step of heat treatment as required taken into consideration, in a variety of preliminarily varied situations including a case where fully refreshed surfaces may not be realized because of the thickness of such an oxide film and a case where the precision of the extrusion required is varied more or less, it will now become apparent that the present invention enables the fin means and the base plate to be firmly fastened with a greater certainty.

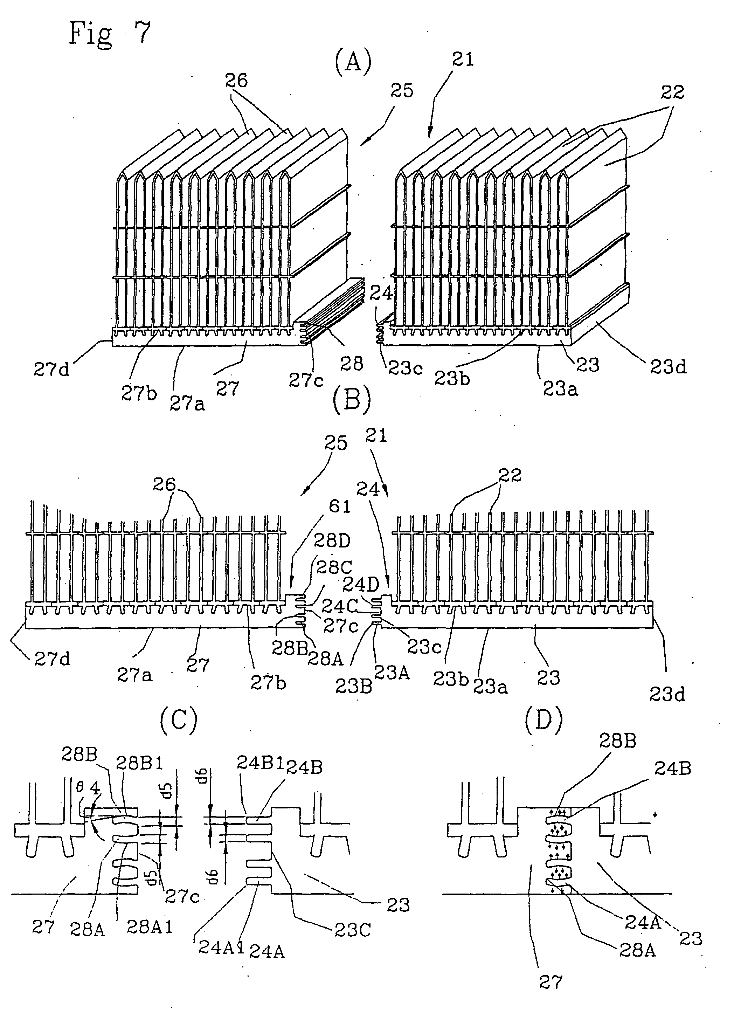

Referring now to Figs. 7(A), 7(B) and 7(C), it will be seen that numeral 22 represents a heat sink that is constituted by a base plate 23 having a surface 23a to which a heat generating element (not shown) is attached; and a plurality of fin means 22 which are attached to a surface 23b that is opposite to the heat generating element attachment surface 23a and which have surfaces on which the heat from the heat generating element is cooled by a coolant air flow or the like passing in contact with these surfaces. The fin means 22 and the base plate 23 have been joined together through the joining surface 23b as mentioned previously in accordance with the present invention. Numeral 25 represents another heat sink that is similar to the heat sink 21 and that is constituted by a base plate 27 having a surface 27a to which a heat generating element (not shown) is attached; and a plurality of fin means 26 which are attached to a surface 27b that is opposite to the heat generating element attachment surface 27a and which have surfaces on which the heat from the heat generating element is cooled by a coolant air flow or the like passing in contact with these surfaces. The fin means 26 and the base plate 27 have been joined together through the joining surface 27b as mentioned previously in accordance with the present invention. Each of the respective constituent parts of the heat sinks 21 and 25, i. e., the fin means 22 and 26 and the base plates 23 and 25, is, here, typically constructed by an extruded member composed of a material that is of a high thermal conductivity, for example, an aluminum material.

One side surface 23c of the base plate 23 of the heat sink 21 is formed to have a width that is greater than that of an opposite side surface 23d of the portion on which the fin means 22 are upstanding, and is formed with a plurality of (here four in number, for example) projecting portions 24. On the other hand, one side surface 77c of the base plate 27 is formed to have a width that is greater than that of an opposite of the portion on which the fin means 26 are upstanding, and is formed with a plurality of (here four in number, for example) recessed portions 28 which correspond in number to the projections 24 of the base plate 23. Thus, the projecting portions 24 of the base plate 23 are adapted to be inserted under pressure into the corresponding recessed portions 28 so that the base plates 23 and 27 may be joined together at the respective sets of the projecting portions 24 and the recessed portions 28 with the side surfaces 23a and 27c as a pair of joining surfaces.

Each of the projecting portions 24A, 24B, 24C and 24D of the base plate 23 is formed to have a rounded forward end and to extend in a direction perpendicular to the joining surface 23c and is formed to have a width d6 that is slightly greater than a width d5 of each of the recessed portions 28A, 28B, 28C and 28D. On the other hand, the recessed portion 28A of the base plate 27 is formed with an internal surface 28A1 that is bent to have a given angle of inclination θ 4 with respect to a direction which is perpendicular to the joining surface 27c whereas the recessed portion 28B is formed with an internal surface 28B1 that is bent to the opposite side to that of the bent portion 8A1 of the recessed portion 28A to have the given angle of inclination θ 4 which is perpendicular to the joining surface 27c. The recessed portions 28A and 28B are shown to have symmetrical arcuate configurations and as being inclined to be opposite to each other. The recessed portions 28C and 28D are formed to have their configurations which are the same as those of the recessed portions 28A and 28B, respectively, which are mentioned above.

An explanation will next be given with respect to a method of preparing a pair of heat sinks which should be composed of extruded metallic materials.

In the heat sinks 21 and 25 constructed as mentioned above, if the projecting portions 24 of the base plate 23 of the heat sink 21 are pressure inserted into the corresponding recessed portions 28 of the base plate 27 of the heat sink 25, respectively, under a pressure amounting to several tens tons that is applied in a short period of time by utilizing a general purpose hydraulic press or the like and a simple jig in a combination, each of the projecting portions 24 will fittedly be inserted into each of the corresponding recessed portions 28 with the forward end of the former rendered to conform in the angle θ 4 to the inside of the latter at the inclined portion.

Withe respect to the state in which the projecting portions 24 are inserted under pressure into the recessed portions 28, a detailed explanation will now be given by taking the projecting portion 24A and the recessed portion 28A as an example.

First of all, it should be noted that prior to the fitted insertion, the external surface of the projecting portion 24A and the internal surface of the recessed portion 28A, as a result of having contacted to the ambient air, has an oxide film formed on each of the surfaces, the oxide film having some degree of thickness.

Next, in the stage of pressure insertion in which the projecting portion 24A is first introduced from the rounded portion at its forward end into the recessed portion 28A, the projecting portion 24A will due to its size tolerance with the recessed portion 28A will suffer a plastic deformation, will thereby be subjected to a work hardening and will thus be hardened.

At this time, since the projecting portion 24A is forcibly inserted into the inclined internal surface portion 28A1 with the angle θ 4, the hardened portion will act to exert a spring force thereto, thus enhancing the tightness of fastening between the projecting portion 24A and the recessed portion 28A.

In connection with the above, it should also be noted that since the extruded members tend to be inconsistent in their tolerance, there may arise a situation in which the work hardening occurs first at the inclined surface portion 28A1 of the recessed portion 28A and an internal stress (i. e., the spring force) then develops within this inclined surface portion.

Also, since the projecting portion 24A is formed to have its width d6 that is slightly greater than the width d5 of the recessed portion 28A and, in other words, since the volume V1 of the projecting portion 24A is made slightly greater than the volume V2 of the recessed portion 28A, it should be noted that there develops a phenomenon that is called "dragging" between the external surface of the projecting portion 24A and the internal surface of the recessed portion 28A.

More specifically, it should be noted that a force of friction will then develop between a boundary portion interfacing the rounded portion of the projecting portion 24A and an external surface thereof perpendicular to the joining surface 23c and the bent internal surface 28A1 of the recessed portion 28 so that the oxide film on the projecting portion 24A having the width d6 and the oxide film on the internal surface of the recessed portion 28A may be scraped away from each other. In addition, it should be noted that the external surface of the projecting portion 24A and the internal surface of the recessed portion 28A will each have a refreshed metallic substrate surface thereof exposed, with both such metallic substrate surfaces mutually developing a dragging action which will join them with an extremely enhanced tightness. Thus, it will be apparent that both the thermal conductivity and the electrical conductivity will, as they are so joined together, be greatly enhanced at their joined interface.

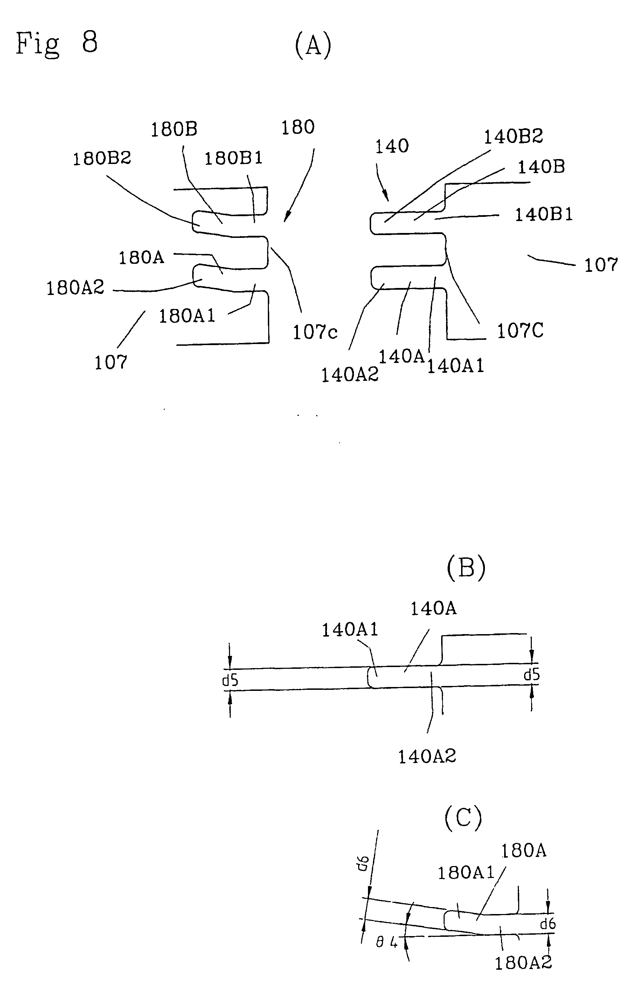

The state in which the projecting portion 24A and the the recessed portion 28A have been joined together after the pressure insertion is shown in Fig. 8(D) where it will be seen that the joining between the projecting portion 24A and the recessed portion 28A will assume a joining state that is achieved primarily by the dragging action. In addition, since the fittedly enterring projecting portion 24A is designed to be sized slightly greater than the fittedly receiving recessed portion 28A and yet since the recessed portion 28A is provided with a portion that is inclined with a given angle relative to a direction perpendicular to the joining surface whilst the projection portion 24A is not angled relative to the direction of the insertion, it can be seen that an internal stress will be generated, in the directions of the arrows shown, by an contraction and an expansion, respectively, of the metallic projecting portion 24A and the metallic recessed portion 28A when the former is fittedly inserted into the latter and a stress will also be generated owing to the fact that the direction of the insertion is not altered while the fitted insertion is being carried out, these stresses being summed up to further enhance the tightness of fastening.

Accordingly, even in a case where the oxide film formed on each on the projecting portion 24A and the recessed portion 28A is so thick that a sufficient dragging state may not develop, it can also be seen that a stress created across the joining surfaces by the pressure applied will give rise to an enhancement of the thermal conductivity between the joined surfaces.

As set forth in the foregoing, it will be understood that the tight fastening between the projecting portion 24A and the recessed portion 28A is accomplished, primarily, by:
(1) a work hardening that is created due to the pressure insertion; and
(2) a stress that is created by angling a hardened metallic body, but, partially, by:
   (1) a work hardening and a dragging action that are created in a combination at the time of the pressure insertion; and
   (2) a spring force that is created due to the fact that a portion which has undergone a work hardening and has been hardened is bent in an internal angled surface portion of a recessed portion: and
that these effects are particularly eminent for a material that is ductile, such as an aluminum or copper material.

On the other hand, it will be apparent that the joining relationship between the projecting portion 24B, 24C, 24D and the recessed portion 28B, 28C, 28D is identical to the joining relationship between the projecting portion 24A and the recessed portion 28A as mentioned above.

Therefore, it follows that the heat that is produced from the heat generating element attached to the base plates 23 and 27 will be thermally conducted via the base plates 23 and 27 which have been so joined as to have an excellent thermal conductivity as mentioned above to the plurality of fin means 222 and the plurality of fin means 62, respectively, with these fins 22 and 26 acting to take away the heat conducted from the base plates 23 and 27 with an air flow from a fan or fans (not shown) attached to the heat sinks 21 and 25.

In connection with the above, it should also be noted that the respective side surfaces 23c and 27c of the two base plates 23 and 27 may be identical in thickness to their other other side surfaces 23d and 27d and may then be formed with a plurality of projecting portions and a plurality of recessed portions, respectively, as mentioned above. If, however, the side surfaces 23c and 27c are made greater in width than the side surfaces 3d and 7d as indicated above, and further the number of projecting portions and the number of recessed portions are increased, it can be seen that the tightness of fastening the base plates 23 and 27 together will further be enhanced.

It should further be noted that whilst the projecting portions 24A, 24B, 24C and 24D are shown as formed each to have a rounded forward end, they may either entirely or partly be formed each with a wedge shaped forward end that is tapered forwards.

Next, Figs. 8(A), 8(B) and 8(C) show a modified embodiment of a plurality of projecting portions and a plurality of recessed portions formed in a pair of base plates, respectively, or a pair of fin means and a base plate, respectively, for a heat sink assembly or unit to which the present invention has been applied.

Here, a joining structure 107 for joining together a pair of base plates or a pair of fin means and a base plate for a heat sink assembly or unit is constructed, in accordance with the present invention, from a plurality of projecting portions 140 of which a pair of projecting portions 140A and 140B are shown and a plurality of recessed portions 180 of which a pair of recessed portions 180A and 180B are shown. Here, the projecting portions 140A and 140B are each shown as having a given width d5 and are each constructed with a caulking portion 140A1, 140B1 that projects from a joining surface 107C in a direction perpendicular thereto and a positioning portion 140A2, 140B2 that further extends from the caulking portions 140A1, 140B1, with the positioning portion 140A2, 140B2 being formed to have a rounded forward end.

On the other hand, the recessed portions 180A and 180B are each shown as having a given width d6 and are each constructed with a positioning portion 180A1, 180B1, that is formed to extend in a direction perpendicular to the joining surface 107c and a caulking portion 180A2, 180B2 that further extends from the positioning portion 180A1, 180B1 while being slightly inclined with an angle θ 4 with respect to the direction perpendicular to the joining surface 107c, with the caulking portion 180A2, 180B2 having a bottom portion that is so rounded as to conform to the rounded forward end of the positioning portion 140A2, 140B2 of the projecting portion 40A, 40B. The width d6 of each recessed portion 180 is sized to be identical to, or slightly smaller than, the width d5 of each projecting portion 140.

Both the positioning portion 140A1, 140B2 of the projecting portion 140A, 140B and the positioning portion 180A1, 180B1 of the recessed portion 180A, 180B have their role to hold their perpendicularity to the joining surfaces 107c when the base plates 23 and 27 or the fin means 21, 26 and the base plate 23, 27 are fittedly inserted into each other, in order that the pressure applied when they are pressure inserted into each other may, without fail, be converted into a force of the fastening between them.

In the construction that is shown Figs. 8(A), 8(B) and 8(C), if the projecting portions 140 are pressure inserted into the respectively corresponding recessed portions 180 under a large pressure, it can be seen that since the width d5 of each projecting portion 140 is made identical to, or slightly greater than, the width d6 of each recessed portion 180 with their size tolerance taken into account as mentioned above, a friction will develop between the external surface of each projecting portion 140 and the internal surface of each recessed portion 180 while providing a dragging action as mentioned above. It can be seen that the dragging action will serve to scrape away an oxide film as formed on the external surface of each projecting portion 140 and an oxide film as formed on the internal surface of each recessed portion 180, thus having a substrate surface of each projecting portion 140 and a substrate surface of each recessed portion 180 exposed as a refreshed external surface of each projecting portion 140 and a refreshed internal surface of each recessed portion 180, respectively. As a result of such an action, it can thus be seen that an extremely tightened joining state will be established each between the positioning portion 140A2, 140B2 of the projecting portion 140A, 140B and the caulking portion 180A2, 180B2 of the recessed portion 180A, 180B and between the positioning portion 180A1, 180B1 of the recessed portion 180A, 180B and the caulking position 140A1, 140B1 of the projecting portion 140A, 140B. Therefore, it follows that both the thermal conductivity and the electrical conductivity of the joining structure 107 will be greatly enhanced.

Also, after the pressure insertion has been carried out, it can be seen that since the positioning portion 140A1, 140B of the projecting portion 140A, 140B has forcibly been bent with the angle θ 4 along the caulking portion 180A2, 180B2 of the recessed portion 180A, 180B with respect to the direction perpendicular to the joining surface 107c, a tightened joining structure 107 will have been established with a greater certainty.

In connection with the foregoing, it may also be noted that as the fin means 22, 26 and base plates 23 and 27 are each constituted by an extruded material, a size tolerance will have been imparted to these plates as a result of the extrusion unlike a case where they are each constituted by a cut material and that such a size tolerance might render the dragging of the base plates 3 and 7 and the fin means 22, 26 insufficient and hence might give rise to the development of a place where an oxide film as formed on the external surface of each projecting portion and an oxide film as formed on the internal surface of each recessed portion are not fully scraped away. Nevertheless, it should be noted that such a portion as is forcibly bent will be plastically deformed to bring about a work hardening thereof, which serves to increase the force of joining the two members together, thereby enhancing the thermal conductivity at the joined interface between them. Stated in other words, it can be noted that the said portion will play a role of compensating for the inconsistency in performance of products, i. e. from one heat sink to another that may arise from the inconsistency in size of products, i. e. from one product to another, as have been extruded.

In this way, it has now become apparent that the two members of a high thermal conductivity will be joined together at their respective projecting and recessed portions primarily by both the dragging action and the work hardening which would take place there and that even in a case where each oxide film is so thick that a sufficient dragging state may not be brought about, the thermal conductivity at their interface can still be enhanced by means of a stress as mentioned above which would be created by the pressure applied.

Still more, it should be noted that whilst the projecting portions 140 are each shown as having a rounded forward end, they may wholly or in part be formed each with a wedge shaped forward end.

According to the present invention, a pair of members composed of a material having a high thermal conductivity is joined together, without requiring a brazing facility and an expensive dedicated machine having the ability to caulk but by using only a general purpose hydraulic press and a simple jig in a combination, to yield an excellently joined product having a superior thermal conductivity.

Also, according to the present invention, when the respective joining surfaces of a pair of such members, e. g. excluded metallic materials, are fitted with each other, there doest it result that they are intensively abraded mutually to the extent that an oxide film as formed of each of the joining surfaces are scraped away to allow a refreshed substrate surface of one of the joining surfaces and a refreshed substrate surface of the other to be exposed, with the refreshed substrate surfaces being subjected to a dragging action so as to be brought into a tightly joined state, thereby enhancing the thermal conductivity at the joined interface

Also, with the extruding technique and the heat treatment step required taken into consideration, even in a variety of preliminarily varied situations including a case where an oxide firm as formed is so thick that a fully refreshed substrate surface may not develop, or a case where the precision of the extrusion required may be varied more or less, it will now become apparent that the present invention enables a pair of members as described to be joined together with a greater certainty.

It should be understood that the present invention is not limited to the specific embodiments thereof set out above, but includes all possible embodiments thereof that can be made within the scope of the appended claims.

## Claims

1. A method of joining together a pair of members (1, 2; 23, 22; 27, 23) composed of a material having a high thermal conductivity, such as aluminium, by fitting them together under pressure in which a first of such members (1 in Figs. 1-6; 23 in Fig. 7; 27 in Fig. 7) is formed by extrusion to have on a surface thereof a recess (shown in but not designated by reference character in Figs. 1, 2 and 4; 1a in Fig. 5; 10a in Fig. 6; 28A-28D in Fig. 7; 180A, 180B in Fig. 8) and a second of such members (2 in Figs. 1-6; 22 in Fig. 7; 23 in Fig. 7) is formed by extrusion to have on a surface thereof a projection (2a in Figs. 1-6; 24A-24D in Fig. 7; 140A, 140B in Fig. 8), said projection of the second member being configured to correspond to, and to be substantially similar in shape to, and having a width that is substantially equal to or slightly greater than that of, said recess of the first member,
said first member (1 in Figs. 1-6; 23 in Fig. 7; 27 in Fig. 7) has said recess (shown in but not designated by reference character in Figs. 1, 2 and 4; 1a in Fig. 5; 10a in Fig. 6; 28A-28D in Fig. 7; 180A, 180B in Fig. 8) formed to lie between and as flanking on two adjacent projections (1a in Figs. 1, 2 and 4; shown in but not designated by reference character in the other Figs.), said recess and said adjacent projections defining a continuous joining surface of said first member along which it is to be joined with said second member;
said first and second members are so formed that each of said adjacent projections of the first member and said projection of the second member is substantially similar in shape to, and has a width that is substantially equal to or slightly greater than that of, the one of said adjacent recesses of the second member and said recess of the first member which is destined to correspond thereto;
said recess and adjacent projections of the first member and said projection and adjacent recesses of the second member each extend generally perpendicular to said continuous joining surfaces of the first and second members, respectively;
each of at least some of said recess and projections of the first member or some of said projection and recesses of the second member is provided with a portion that is inclined with a given angle (θ 1, θ 2, θ 4) to said perpendicular to said joining surfaces; **characterised in that**:
said second member has said projection formed to lie between and as flanking on two adjacent recesses, said projection and adjacent recesses defining a continuous joining surface of said second member along which it is to be joined with said first member;
said first and second members are fitted under pressure together by forcibly inserting said projection of the second member under pressure into said recess of the first member while concurrently permitting said adjacent projections of the first member under pressure to be forcibly inserted into said corresponding, adjacent recesses of the second member, respectively.

2. A method of joining as set forth in claim 1, **characterized in that** said projections and recesses are so configured and fitting under pressure is so carried out, as in the forcible inserting stage:
1) to cause areas of said projections and recesses with said portion inclined to be dynamically affected under pressure and thereby plastically deformed to effect a work hardening thereof;
2) to develop an internal stress in said areas from a contraction and expansion of said projections entering and said recesses receiving when driven together under pressure; and
3) to induce a dragging action in said areas from said stress developed and a frictional force dynamically produced between said entering projections and receiving recesses with said portion inclined,
thereby fastening tightly and thus joining said two members together under a combined effect of said work hardening, said internal stress developed and said dragging action induced.

3. A method of joining as set forth in claim 1 or claim 2, **characterized in that** said first and second members are each constituted by a base plate for a heat sink.

4. A method of joining as set forth in claim 1 or claim 2, **characterized in that** one of said first and second members is constituted by fin means and the other by a base plate for a heat sink assembly.

## Patentansprüche

1. Verfahren zur Verbindung eines Paares von Werkstücken (1, 2; 23, 22; 27, 23), die aus einem Material mit einer hohen thermischen Leitfähigkeit wie Aluminium bestehen, indem diese unter Druck zusammengefügt werden, wobei ein erstes Werkstück der genannten Werkstücke (1 in Fig. 1-6; 23 in Fig. 7; 27 in Fig. 7) durch Umformung gebildet ist, um an einer Oberfläche eine Vertiefung (in Fig. 1, 2 und 4 dargestellt, jedoch nicht mit einem Bezugszeichen versehen; 1a in Fig. 5; 10a in Fig. 6; 28A-28D in Fig. 7; 180A, 180B in Fig. 8) aufzuweisen, und ein zweites Werkstück der genannten Werkstücke (2 in Fig. 1-6; 22 in Fig. 7; 23 in Fig. 7) durch Umformung gebildet ist, um an einer Oberfläche einen Vorsprung (2a in Fig. 1-6; 24A-24D in Fig. 7; 140A, 140B in Fig. 8) aufzuweisen, wobei der Vorsprung des zweiten Werkstückes so eingerichtet ist, dass er der Vertiefung des ersten Werkstückes entspricht und eine zu dieser im wesentlichen ähnliche Gestalt sowie eine Weite aufweist, die im wesentlichen gleich oder geringfügig größer als die der Vertiefung des ersten Werkstückes ist,
das erste Werkstück (1 in Fig. 1-6; 23 in Fig. 7; 27 in Fig. 7) die Vertiefung (in Fig. 1, 2 und 4 dargestellt, jedoch nicht mit einem Bezugszeichen versehen; 1a in Fig. 5; 10a in Fig. 6; 28A-28D in Fig. 7; 180A, 180B in Fig. 8) als zwischen und zwei benachbarte Vorsprünge (1a in Fig. 1, 2 und 4; in den anderen Figuren dargestellt jedoch nicht mit einem Bezugszeichen versehen) flankierend angeordnet aufweist, wobei die Vertiefung und die benachbarten Vorsprüngen eine durchgehende Verbindungsoberfläche des ersten Werkstückes bilden, entlang der es mit dem zweiten Werkstück verbunden wird,
das erste und zweite Werkstück so ausgebildet sind, dass jede der benachbarten Vorsprüngen des ersten Werkstückes und der Vorsprung des zweiten Werkstückes in Bezug auf die benachbarten Vertiefungen des zweiten Werkstückes und der Vertiefung des ersten Werkstückes, das hierzu entsprechend vorgesehen ist, im wesentlichen von ähnlicher Gestalt sind und eine Weite aufweisen, die im wesentlichen gleich oder geringfügig größer ist,
die Vertiefung und die benachbarten Vorsprünge des ersten Werkstückes sowie der Vorsprung und die benachbarten Vertiefungen des zweiten Werkstückes jeweils im wesentlichen rechtwinklig zu den durchgehenden Verbindungsoberflächen des jeweiligen ersten und zweiten Werkstückes ausgerichtet sind,
wenigstens einige aus der Gesamtheit der Vertiefung und der Vorsprünge des ersten Werkstückes oder einige aus der Gesamtheit des Vorsprungs und der Vertiefungen des zweiten Werkstückes mit einem Abschnitt ausgebildet sind, der mit einem vorgegebenen Winkel (θ 1, θ 2, θ 4) zu der Normalen auf die Verbindungsoberflächen geneigt ist, **dadurch gekennzeichnet, dass**
das zweite Werkstück den Vorsprung als zwischen und zwei benachbarte Vertiefungen flankierend angeordnet aufweist, wobei der Vorsprung und die benachbarten Vertiefungen eine durchgehende Verbindungsoberfläche des zweiten Werkstückes bilden, entlang der es mit dem ersten Werkstück verbunden wird,
das erste und zweite Werkstück unter Druck durch Einfügen mit Kraftanwendung des Vorsprungs des zweiten Werkstückes unter Druck in die Vertiefung des ersten Werkstückes miteinander verbunden werden, während gleichzeitig den benachbarten Vorsprüngen des ersten Werkstückes unter Druck das Einfügen mit Kraftanwendung in zugeordnete benachbarte Vertiefungen des zweiten Werkstückes gestattet wird.

2. Verfahren zur Verbindung nach Anspruch 1, **dadurch gekennzeichnet, dass** die Vorsprünge und Vertiefungen so ausgebildet und das Einpassen unter Druck so ausgeführt wird, dass bei dem unter Kraftanwendung stattfindenden Einfügeschritt
1) Bereiche der Vorsprünge und Vertiefungen mit dem geneigten Abschnitt unter Druck dynamisch zusammenwirken und unter Herbeiführen einer Kaltverfestigung dabei plastisch verformt werden,
2) sich eine innere Beanspruchung in den Bereichen durch ein Zusammendrücken und Ausdehnen der eintretenden Vorsprünge und der aufnehmenden Vertiefungen entwickelt, wenn sie unter Druck zusammengeführt werden, und
3) eine Mitnahmewirkung durch die ausgebildete Beanspruchung und eine dynamisch erzeugte Reibungskraft zwischen den eintretenden Vorsprüngen und aufnehmenden Vertiefungen mit dem geneigten Abschnitt hervorgerufen wird,
wobei hierdurch eine fester Schluß und damit eine Verbindung zwischen den beiden Werkstücken unter einem kombinierten Effekt der Kaltverfestigung, der ausgebildeten Beanspruchung und der induzierten Mitnahmewirkung herbeigeführt wird.

3. Verfahren zur Verbindung nach Anspruch 1 oder Anspruch 2, **dadurch gekennzeichnet, dass** das erste und zweite Werkstück jeweils durch eine Grundplatte für eine Wärmesenke gebildet sind.

4. Verfahren zur Verbindung nach Anspruch 1 oder Anspruch 2, **dadurch gekennzeichnet, dass** ein Werkstück aus der Gesamtheit des ersten Werkstückes und des zweiten. Werkstückes durch rippenartige Mittel und das andere Werkstück durch eine Grundplatte für eine Wärmesenkenanordnung gebildet ist.

## Revendications

1. Méthode pour assembler deux pièces (1,2; 23,22; 27,23) composées d'une matière ayant une haute conductivité thermique, telle que l'aluminium, en les emboîtant sous pression, dans laquelle la première de ces pièces (1 dans les Fig. 1-6; 23 dans la Fig. 7; 27 dans la Fig.7) est formée par boudinage de façon à comporter à sa surface un enfoncement (illustré, mais sans référence dans les Fig. 1,2 et 4; la dans la Fig. 5; 10a dans la Fig. 6; 28A-28D dans la Fig. 7; 180A, 180B dans la Fig. 8) et la deuxième pièce (2 dans les Figs. 1-6; 22 dans la Fig. 7; 23 dans la Fig. 7) est formée par boudinage de façon à être pourvue d'une saillie (2a dans les Figs. 1-6, 24A-24D dans la Fig.7; 140A, 140B dans la Fig.8), cette saillie de la deuxième pièce étant configurée de façon à correspondre à l'enfoncement susmentionné de la première pièce et à avoir une forme substantiellement semblable à cet enfoncement et une largeur substantiellement égale ou légèrement plus grande que ledit enfoncement sur la première pièce,
la première pièce (1 dans les Figs. 1-6; 23 dans la Fig. 7; 27 dans la Fig. 7) ) a un enfoncement ((illustré, mais sans référence dans les Fig. 1,2 et 4; la dans la Fig 5; 10a dans la Fig. 6; 28A-28D dans la Fig 7; 180A.180B dans la Fig. 8) formé de façon à se trouver entre et flanquant deux saillies adjacentes (1a dans les Figs. 1,2 et 4; illustrées, mais sans référence dans les autres Figures), ledit enfoncement et saillies adjacentes définissant une surface continue servant à les raccorder avec la deuxième pièce;
la première et la deuxième pièce sont formées de telle façon que chacune desdites saillies adjacentes de la première pièce et ladite saillie de la deuxième pièce est substantiellement semblable par sa forme à l'un des enfoncements adjacents et qu'elle a une largeur substantiellement égale à, ou légèrement plus grande que, l'un des enfoncements adjacents, dans le cas de la deuxième pièce, et que l'enfoncement de la première pièce qui est prévu pour y correspondre;
lesdits enfoncement et saillies adjacentes de la première pièce et lesdits saillies et enfoncements adjacents de la deuxième pièce s'étendent chacun d'une façon généralement perpendiculaire aux dites surfaces continues de raccordement des première et deuxième pièces respectivement;
chacun et au moins quelques uns desdits encochements et saillies de la première pièce ou quelques uns desdits saillies et encochements de la deuxième pièce sont pourvus d'une portion qui est inclinée à un angle donné (θ 1, θ 2, θ 4) par rapport à la perpendiculaire aux surfaces de raccordement; **caractérisée en ce que:**
dans la deuxième pièce, cette saillie est faite de façon à se loger entre deux encochements adjacents en les flanquant, cette saillie et les encochements adjacents définissant une surface de raccordement continue de cette deuxième pièce le long de laquelle doit se faire le raccordement avec la première pièce;
la première et la deuxième pièce sont emboîtées ensemble sous pression en insérant par forcement la saillie de la deuxième pièce sous pression dans l'enfoncement de la première pièce, en permettant en même temps aux saillies adjacentes de la première pièce sous pression d'être insérées par forcement dans les encochements correspondants de la deuxième pièce, respectivement.

2. Méthode d'assemblage selon la revendication 1, **caractérisée en ce que** les saillies et les encochements sont configurés et l'emboîtement sous pression exécuté dans l'étape d'insertion par forcement de manière à:
1) causer les régions de ces saillies et ces encochements avec une portion inclinée à être affectées dynamiquement sous pression et donc plastiquement déformées pour effectuer un durcissement à froid;
2) développer une tension intérieure dans ces régions par contraction et expansion de ces saillies entrant dans ces enfoncements et par ces enfoncements les recevant quand elles sont rapprochées sous pression; et
3) induire un effet de traînage dans ces régions causé par la tension qui se développe et une force de friction produite dynamiquement entre les saillies entrant les encochements à portion inclinée et les encochements les recevant; serrant par ce fait fortement et joignant les deux pièces l'une à l'autre sous un effet combiné de durcissement à froid, de tension intérieure et d'effet de traînage.

3. Méthode d'assemblage comme décrite dans la revendication 1 ou 2, **caractérisée en ce que** la première et la deuxième pièce sont constituées chacune par une plaque de base pour un dissipateur de chaleur.

4. Méthode d'assemblage selon la revendication 1 ou 2, **caractérisée en ce qu'**une des première ou deuxième pièces est constituée par un dispositif en forme de nageoire et l'autre par une plaque de base d'un dissipateur de chaleur.
